# EUROPEAN PATENT APPLICATION

(11) **EP 4 442 867 A1**
(43) Date of publication of application: **09.10.2024**
(21) Application number: 22901011.1
(22) Date of filing: 31.10.2022
(51) Int. Cl.: C30B 29/04, C23C 16/27, C23C 16/511, C30B 25/02, C30B 25/18, H01L 21/20

(54) **METHOD FOR FORMING MONOCRYSTALLINE DIAMOND FILM**

(30) Priority: 02.12.2021 JP 2021196363
(71) Applicant: Shin-Etsu Handotai Co., Ltd., Tokyo 100-0004 (JP)
(72) Inventor: QU Weifeng, Annaka-shi, Gunma 379-0196 (JP); IGAWA Shizuo, Annaka-shi, Gunma 379-0196 (JP); SUNAKAWA Ken, Annaka-shi, Gunma 379-0196 (JP)
(74) Representative: Mooser, Sebastian Thomas
(86) International application number: PCT/JP2022/040822
(87) International publication number: WO 2023/100578

(57) **Abstract**

The present invention is a method for forming a monocrystalline diamond film on a monocrystalline silicon substrate. The method includes a first step of preparing a monocrystalline silicon substrate having a plane orientation of (100) or (111), a second step of performing an RTA treatment on the prepared monocrystalline silicon substrate in a carbon-containing atmosphere to form a 3C-SiC monocrystalline film on the surface of the monocrystalline silicon substrate, a third step of converting the 3C-SiC monocrystalline film into diamond nuclei by using a microwave plasma CVD method, in which a bias voltage is applied in a carbon-containing atmosphere, to form the diamond nuclei on the monocrystalline silicon substrate, and a fourth step of causing a monocrystalline diamond film to grow on the monocrystalline silicon substrate by using the microwave plasma CVD method in a carbon-containing atmosphere. By the above method, high density diamond nuclei are formed, and a method for forming a large area monocrystalline diamond film that exhibits excellent crystal orientation and has no grain boundary in the film is provided.

## Description

### TECHNICAL FIELD

The present invention relates to a method for forming a monocrystalline diamond film. In particular, the present invention provides a method for forming a large area monocrystalline diamond film that exhibits excellent crystal orientation and has no grain boundary in the film.

### BACKGROUND ART

Diamond has excellent heat resistance, and has a band gap of as high as 5.5 eV. Characteristically, diamond is normally an insulator, but can be converted to a semiconductor by doping with impurities.

Moreover, diamond has excellent electrical properties such as high dielectric breakdown voltage, high saturation drift velocity, and small dielectric constant. Thus, diamond is expected as an electronic device and sensor material for high temperature, high frequency, or high electric field applications.

Examples of known methods for vapor phase synthesis of diamond include a microwave CVD (Chemical Vapor Deposition) method (Non Patent Documents 1 to 3), high frequency plasma CVD method, hot filament CVD method, direct current plasma CVD method, plasma jet method, combustion method, and thermal CVD method.

### CITATION LIST

### PATENT LITERATURE

Patent Document 1: JP H08-239296 A

### NON PATENT LITERATURE

Non Patent Document 1: H. Kawarada and four others, "Heteroepitaxial growth of highly oriented diamond on cubic silicon carbide," "Journal of Applied Physics," (the United States), April 15, 1997, volume 81, no. 8, pp. 3490-3493.
Non Patent Document 2: Kazuki Ohtsuka and three others, "Epitaxial Growth of Diamond on Iridium," "Japanese Journal of Applied Physics," August 15, 1993, volume 35, no. 8B, pp. L1072-L1074.
Non Patent Document 3: Yoshihiro Shintani, "Growth of Highly(111)-oriented, highly coalesced diamond films on platinum(111) surface: A possibility of heteroepitaxy," "Journal of Material Research," November 1996, volume 11, no. 12, pp.2955-2956.

### SUMMARY OF INVENTION

### TECHNICAL PROBLEM

The lattice mismatch rate between diamond and Si is about 34%. Thus, diamond and silicon have significantly different lattice constant. Therefore, in forming a diamond monocrystalline film by a MPCVD (Microwave Plasma Chemical Vapor Deposition) method, a method using a SiC substrate (Non Patent Document 1) or a metal Pt film (Non Patent Document 3) is proposed to decrease the lattice mismatch rate with diamond.

Additionally, a method including applying a bias voltage to a silicon monocrystalline substrate during a MPCVD process to promote degradation of hydrocarbon on the silicon monocrystalline substrate, thereby forming diamond nuclei in a 3C-SiC layer to form a monocrystalline diamond film has been employed.

However, with the above method, 3C-SiC diamond nuclei are hardly formed, and the surface density of the 3C-SiC diamond nuclei is as low as about 1×10⁸ to 1×10¹⁰/cm². Accordingly, it is difficult to cause monocrystalline diamond to grow. Moreover, there is also a problem in the surface flatness due to the presence of significant grain boundaries.

In addition, film formation speed of a conventional microwave plasma CVD apparatus is about 0.2 µm/hr. Thus, vapor phase synthesis should be performed for a long time for forming a film with a thickness of several hundred µm, so that production cost increases. On the other hand, a large microwave CVD apparatus with input power of equal to or more than 60 kW can form a film at high speed, and thus is suitable for increasing film thickness. However, the technology for synthesizing a diamond film in which crystal planes are oriented has not been examined.

Accordingly, a technology for the vapor phase synthesis of a thick diamond film with no grain boundary in which crystal planes are oriented in a wide area has not been established yet.

Other than these, when using a silicon monocrystalline substrate, a method using an Ir buffer layer is also proposed (Non Patent Document 2). In this method, by forming an intermediate layer (buffer layer) of a noble metal simple substance or noble metal alloy having a (111) or (001) crystal plane, the surface density of diamond nuclei is increased to 1×10¹¹/cm², thereby performing vapor phase synthesis of a monocrystalline diamond film by fusion growth.

However, there is a problem that the diamond film is separated from a substrate, and further, similarly to Non Patent Documents 1 and 3, a region with no grain boundary is small.

Furthermore, Patent Document 1 discloses that a SiC monocrystalline film is formed on a silicon substrate, an amorphous carbon film is formed on the SiC monocrystalline film by supplying CH₄ gas, and then by giving energy from outside, the amorphous carbon film is crystallized and converted to a monocrystalline diamond film, and further a diamond monocrystalline film is grown epitaxially.

However, such method for converting an amorphous carbon film into a monocrystalline diamond film by giving high energy randomly changes the sp2 structure to the sp3 structure. As a consequence, the orientation of diamond nuclei also becomes random, and a highly oriented monocrystalline diamond film cannot be obtained.

The present invention was made in view of the above-mentioned problems, and has for its object to provide a method for forming a large area monocrystalline diamond film in which high density diamond nuclei are formed and which exhibits excellent crystal orientation and has no grain boundary in the film.

### SOLUTION TO PROBLEM

For achieving the above object, the present invention provides a method for forming a monocrystalline diamond film on a monocrystalline silicon substrate, the method including:
a first step of preparing a monocrystalline silicon substrate having a plane orientation of (100) or (111), as the monocrystalline silicon substrate;
a second step of performing an RTA treatment on the monocrystalline silicon substrate prepared in the first step in a carbon-containing atmosphere to form a 3C-SiC monocrystalline film on a surface of the monocrystalline substrate;
a third step of converting the 3C-SiC monocrystalline film into a diamond nucleus by using a microwave plasma CVD method, in which a bias voltage is applied in a carbon-containing atmosphere, to form the diamond nucleus on the monocrystalline silicon substrate after the second step; and
a fourth step of causing a monocrystalline diamond film to grow on the monocrystalline silicon substrate by using the microwave plasma CVD method in a carbon-containing atmosphere after the third step.

By the method for forming a monocrystalline diamond film of the present invention as described above, it is possible to form highly oriented diamond nuclei by preparing and using the monocrystalline silicon substrate having a plane orientation of (100) or (111).

Furthermore, because the 3C-SiC monocrystalline film is formed on the surface of the monocrystalline silicon substrate by a sublimation method with an RTA (Rapid Thermal Annealing) treatment, carbon concentration can be made higher than silicon concentration at an outermost surface of the 3C-SiC monocrystalline film. By converting the 3C-SiC monocrystalline film described above into diamond nuclei, it is possible to uniformly form high density diamond nuclei on the entire surface of the monocrystalline silicon substrate.

In addition, the high density diamond nuclei formed on the surface of the 3C-SiC monocrystalline film are highly oriented. Therefore, SiC with sp3 structure can be easily converted into diamond with sp3 structure.

As a result, it is possible to synthesize a thick monocrystalline diamond film with no grain boundary, in which crystal planes are oriented, in a wide area in a vapor phase.

At this time, the 3C-SiC monocrystalline film formed in the second step may have a thickness of equal to or more than 0.5 nm and equal to or less than 10 nm, and have a carbon concentration higher than an Si concentration at an outermost surface of the 3C-SiC monocrystalline film.

By forming such a thick 3C-SiC monocrystalline film, Si is less likely to be sublimated from the surface of the monocrystalline silicon substrate. Thus, the carbon concentration at an outermost surface of the 3C-SiC monocrystalline film can be made higher than the Si concentration more reliably. Thereby, high density diamond nuclei can be formed more reliably on the surface of the 3C-SiC monocrystalline film.

The carbon-containing atmosphere may be an atmosphere containing equal to or more than 0.5% and equal to or less than 10% of CH₄, and a heat treatment temperature may be equal to or more than 1100°C and equal to or less than 1350°C in the second step.

By performing the second step in the conditions as above, the 3C-SiC monocrystalline film can be formed to have a uniform surface state more reliably. Thus, it is possible to convert the 3C-SiC monocrystalline film into highly oriented diamond nuclei.

The third step may be performed after the monocrystalline silicon substrate, on the surface of which the 3C-SiC monocrystalline film is formed, may be divided into a size that can be placed in a microwave plasma CVD apparatus.

The formation of the diamond nuclei and the growth of the monocrystalline diamond film are performed with a microwave plasma method, and thus the monocrystalline silicon substrate, on the surface of which the 3C-SiC monocrystalline film is formed, is preferably divided into a size that can be placed in the microwave plasma CVD apparatus.

The diamond nucleus formed in the third step may have average surface density of equal to or more than 1×10¹¹/cm².

Thereby, a monocrystalline diamond film with no grain boundary can be effectively grown and formed in the subsequent growth step of the monocrystalline diamond film.

The carbon-containing atmosphere may be an atmosphere containing equal to or more than 0.5% and equal to or less than 5.5% of CH₄, a bias voltage may be equal to or more than 400 V and equal to or less than 800 V, and a heat treatment temperature may be equal to or more than 900°C and equal to or less than 1200°C in the third step.

By performing the third step in the conditions as above, the average surface density of the diamond nuclei can be controlled to be high more easily. For example, the average surface density can be controlled to equal to or more than 1×10¹¹/cm².

The carbon-containing atmosphere may be an atmosphere containing equal to or more than 0.5% and equal to or less than 5.5% of CH₄, and a heat treatment temperature may be equal to or more than 850°C and equal to or less than 1150°C in the fourth step.

By performing the fourth step in the conditions as above, a highly oriented and thick monocrystalline diamond film with no grain boundary can be formed more reliably.

The monocrystalline diamond film that is caused to grow in the fourth step may have a thickness of equal to or more than 50 µm.

According to the method for forming diamond of the present invention, it is possible to form a highly oriented monocrystalline diamond film with no grain boundary, in particular having a large thickness of equal to or more than 50 um.

### ADVANTAGEOUS EFFECTS OF INVENTION

According to the method for forming a monocrystalline diamond film of the present invention, it is possible to form diamond nuclei uniformly in high density on a monocrystalline silicon substrate, and also to obtain a large area monocrystalline diamond film having no grain boundary, excellent crystal orientation, and a large thickness.

### BRIEF DESCRIPTION OF DRAWINGS

FIG. 1 is a flow diagram showing an example of steps of the method for forming a monocrystalline diamond film according to the present invention;
FIG. 2 is a SEM observation view showing a substrate surface on which diamond nuclei in Example are formed;
FIG. 3 is a TEM observation view showing a section of a substrate surface layer on which the diamond nuclei in Example are formed;
FIG. 4 is a graph showing evaluation results of Raman spectroscopy for the diamond nuclei in Example;
FIG. 5 is an observation view of a diamond film in Example;
FIG. 6 is a graph showing evaluation results of Raman spectroscopy of a monocrystalline diamond film in Example;
FIG. 7 is a SEM observation view showing a surface of the monocrystalline diamond film in Example; and
FIG. 8 is a SEM observation view showing surface layer sections of a substrate and the monocrystalline diamond film in Example.

### DESCRIPTION OF EMBODIMENTS

The present inventors made intensive investigations on the above-described problems. As a result, they conceived to form a 3C-SiC monocrystalline film on the surface of a monocrystalline silicon substrate, and to form a highly oriented and thick monocrystalline diamond film with no grain boundary from the 3C-SiC monocrystalline film. For this purpose, they conceived that the surface density of diamond nuclei is required to be higher in forming the diamond nuclei from the 3C-SiC monocrystalline film.

Then, they found that by forming the 3C-SiC monocrystalline film by an RTA treatment with a sublimation method, carbon concentration can be made higher than Si concentration at an outermost surface of the 3C-SiC monocrystalline film, and high density diamond nuclei can be formed by a MPCVD method in which a bias voltage is applied. They further found that a highly oriented and thick monocrystalline diamond film with no grain boundary can be formed by causing a monocrystalline diamond film to grow from the diamond nuclei by the MPCVD method. Thereby, the present invention was completed.

Hereinafter, the present invention will be described in more detail. However, the present invention is not limited thereto.

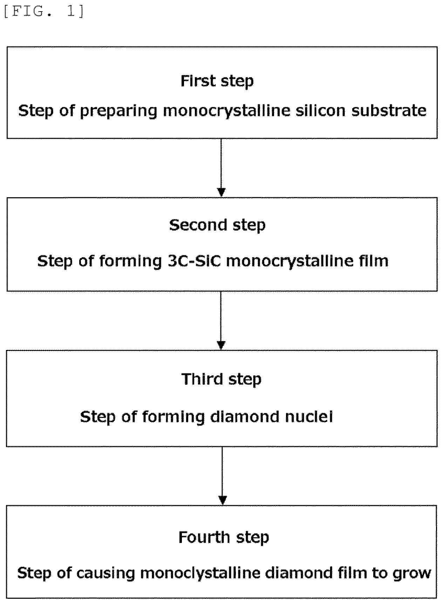

FIG. 1 shows a flow diagram of the method for forming a monocrystalline diamond film according to the present invention. The method roughly includes four steps. That is, a first step of preparing a monocrystalline silicon substrate, a second step of forming a 3C-SiC monocrystalline film, a third step of forming diamond nuclei, and a fourth step of causing a monocrystalline diamond film to grow are included. Hereinafter, each step will be described in detail.

### <First Step> Step of Preparing Monocrystalline Silicon Substrate

A monocrystalline silicon substrate having a plane orientation of (100) or (111) is prepared.

The oriented growth is dependent on the fastest growth orientation of diamond. Growth in the plane orientation of (100) and (111) is fast. Thus, by using a monocrystalline silicon substrate having such plane orientation, highly oriented diamond nuclei can be formed.

### <Second Step> Step of Forming 3C-SiC Monocrystalline Film

By performing the RTA treatment, a 3C-SiC monocrystalline film is formed on the surface of the monocrystalline silicon substrate with a sublimation method. Apparatus to be used in the RTA treatment is not particularly limited, and for example, a conventionally used RTA apparatus can be used.

In a quartz chamber of the RTA apparatus, the monocrystalline silicon substrate is placed, and then the RTA treatment is performed in a carbon-containing atmosphere with a carrier gas such as Ar gas or hydrogen gas.

The film thickness of the 3C-SiC monocrystalline film formed at this time is not particularly limited, and may be, for example, equal to or more than 0.5 nm and equal to or less than 10 nm.

When the film thickness of the 3C-SiC monocrystal is equal to or more than 0.5 nm, the carbon concentration at the outermost surface of the 3C-SiC monocrystalline film can be made higher than the Si concentration more reliably. Thereby, high density diamond nuclei can be formed more reliably in the next third step. In the formation of the 3C-SiC monocrystalline film with the sublimation method using the RTA treatment, as the thickness of the 3C-SiC monocrystalline film increases, an amount of Si supplied from the interface to the reaction surface of the monocrystalline silicon substrate decreases. Thus, the carbon concentration at the outermost surface of the 3C-SiC monocrystalline film increases. From the viewpoint of carbon concentration, 10 nm thickness is enough, and if the thickness exceeds 10 nm, growth of the 3C-SiC monocrystalline film stops.

In the second step, the RTA treatment may be performed in a carbon-containing atmosphere. The conditions are not particularly limited, and for example, may be a carbon-containing atmosphere containing equal to or more than 0.5% and equal to or less than 10% of CH₄, and the heat treatment temperature of equal to or more than 1100°C and equal to or less than 1350°C.

In the carbon-containing atmosphere, when the concentration of CH₄ is equal to or more than 0.5%, it is possible to effectively prevent formation of "island shape" discontinuous 3C-SiC monocrystalline film, as a result of failure of growth of a uniform 3C-SiC monocrystalline film on the surface of the monocrystalline silicon substrate. In other words, a 3C-SiC monocrystalline film having a more uniform surface state can be formed, and highly oriented diamond nuclei can be formed more reliably in the next third step. On the other hand, when the concentration of CH₄ is equal to or less than 10%, the 3C-SiC monocrystalline film can be formed without any particular problem, and the surface of the quartz chamber of the RTA apparatus can be prevented from easily becoming dirty.

Note that the gas introduced for making carbon-containing atmosphere is not limited to CH₄, and may be C₂H₆ or C₃H₈. This is not only applied to the second step, but also to the third step and fourth step described below.

Furthermore, by setting the heat treatment temperature to equal to or more than 1100°C, it is possible to efficiently form a thick 3C-SiC monocrystalline film at favorable film-formation speed. On the other hand, when the heat treatment temperature is equal to or less than 1350°C, the quartz chamber of the RTA apparatus can be prevented from becoming dirty as a result of rapid decomposition of carbon due to excessively high heat treatment temperature.

The temperature raising rate, temperature lowering rate, and retention time of the heat treatment temperature are not particularly limited. For example, the temperature raising rate and the temperature lowering rate may be 10 to 50°C/sec, and the retention time may be 1 to 100 sec. These conditions may be determined as appropriate according to the thickness of the film to be formed, and the like.

### <Third Step> Step of Forming Diamond Nuclei

The 3C-SiC monocrystalline film formed in the second step is converted into diamond nuclei by the MPCVD method in which a bias voltage is applied in a carbon-containing atmosphere, thereby forming diamond nuclei on the monocrystalline silicon substrate. The apparatus to be used in the treatment by the MPCVD method is not particularly limited, and for example, a conventionally used MPCVD apparatus can be used.

Carbon atoms of diamond nuclei are supplied not only from carbon atoms in the 3C-SiC monocrystalline film, but also from the carbon-containing atmosphere. Si atoms in the 3C-SiC monocrystalline film are discharged outside the apparatus together with a carrier gas.

Firstly, due to relation between sizes of the MPCVD apparatus and of an object to be treated, where necessary, the monocrystalline silicon substrate, on the surface of which the 3C-SiC monocrystalline film is formed in the second step, can be divided. For example, the monocrystalline silicon substrate may be divided to about a 20 mm square and placed in the MPCVD apparatus. The division size may be appropriately determined. Of course, if possible, the whole substrate may be placed in the MPCVD apparatus without being divided and subjected to the treatment. In that case, a larger monocrystalline diamond film can be eventually obtained.

Incidentally, a diamond nucleus has a sp3 structure of a three-dimensional structure. Because 3C-SiC also has the same sp3 structure, with a method of converting 3C-SiC into diamond nuclei, the diamond nuclei can be formed even with a low energy.

At this time, by placing the substrate (or divided substrate) after the second step in a chamber of the MPCVD apparatus, making a carbon-containing atmosphere with Ar gas or hydrogen gas as a carrier gas, and while applying a bias voltage to the substrate having a 3C-SiC monocrystalline film that has a carbon concentration higher than Si concentration at the surface of the film obtained in the second step, converting the 3C-SiC monocrystalline film into diamond nuclei by the MPCVD method, the conversion into diamond nuclei can be performed more efficiently, and high density diamond nuclei can be formed more efficiently.

The conditions of MPCVD may be appropriately determined according to the thickness of the 3C-SiC monocrystalline film formed in the second step, or the like, and may be, for example, a carbon-containing atmosphere containing equal to or more than 0.5% and equal to or less than 5.5% of CH₄, a bias voltage of equal to or more than 400 V and equal to or less than 800 V, and a heat treatment temperature of equal to or more than 900°C and equal to or less than 1200°C.

At this time, in particular, when the concentration of CH₄ is equal to or more than 0.5% in the carbon-containing atmosphere, the bias voltage is equal to or more than 400 V, and the heat treatment temperature is equal to or more than 900°C, high density diamond nuclei can be formed more reliably. On the other hand, when the concentration of CH₄ is equal to or less than 5.5%, the bias voltage is equal to or less than 800 V, and the heat treatment temperature is equal to or less than 1200°C, the diamond nuclei can be controlled to have highly-oriented crystallinity more reliably.

With the conditions as above, the average surface density of the diamond nuclei that is converted and formed from the 3C-SiC monocrystalline film can be controlled to be at high density more easily. In particular, the average surface density can be controlled to equal to or more than 1×10¹¹/cm². When the average surface density is equal to or more than 1×10¹¹/cm², a monocrystalline diamond film with no grain boundary can be grown more reliably in the next fourth step. The upper limit of the average surface density of the diamond nuclei is not limited. The higher the average surface density is, the more preferable it is.

### <Fourth Step> Growth Step of Monocrystalline Diamond Film

Next, a monocrystalline diamond film is caused to grow on the monocrystalline silicon substrate by the MPCVD method in a carbon-containing atmosphere. The same MPCVD apparatus as in the third step can be used.

The MPCVD conditions at this time may be, for example, a carbon-containing atmosphere containing equal to or more than 0.5% and equal to or less than 5.5% of CH₄, and the heat treatment temperature of equal to or more than 850°C and equal to or less than 1150°C.

In the carbon-containing atmosphere, when the concentration of CH₄ is equal to or more than 0.5%, and the heat treatment temperature is equal to or more than 850°C, a growth speed of the monocrystalline diamond film is fast, and a thick monocrystalline diamond film can be effectively formed. On the other hand, when the concentration of CH₄ is equal to or less than 5.5%, and the heat treatment temperature is equal to or less than 1150°C, the growth speed of the film does not become too fast, and it is sufficiently possible to control the film in highly-oriented crystallinity.

A highly-oriented monocrystalline diamond film with no grain boundary can be formed more reliably by forming the film under the conditions described above. Moreover, it is sufficiently possible to obtain a thick and large area monocrystalline diamond film. In particular, a thick monocrystalline diamond film having a thickness of equal to or more than 50 um can be formed. Note that 100 um thickness is enough. On the surface of the monocrystalline silicon substrate, the 3C-SiC monocrystalline film with a small thickness remains unconverted, and a thick monocrystalline diamond film is formed thereon.

### EXAMPLE

Hereinafter, the present invention will be more specifically described with reference to Example and Comparative Examples. However, the present invention is not limited thereto.

### (Example 1)

As described below, a diamond film was formed by the method for forming a monocrystalline diamond film according to the present invention that is shown in FIG. 1.

### <First Step>

A monocrystalline silicon substrate having a diameter of 200 mm and a plane orientation of (100) was prepared.

### <Second Step>

A 3C-SiC monocrystalline film with a film thickness of 3 nm was formed using an RTA apparatus (apparatus name: AST2800, manufactured by Mattson Technology, Inc.) with an RTA treatment under the following conditions. Carbon-containing atmosphere: Ar+H₂ atmosphere containing 1.4% of CH₄
Heat treatment temperature: 1200°C/10 sec, temperature raising rate: 25°C/sec, and temperature lowering rate:
33°C/sec

### <Third Step> The monocrystalline silicon substrate with the 3C-SiC monocrystalline film after the second step was cleaved and divided into 20 mm squares.

Thereafter, conversion and formation of diamond nuclei from the 3C-SiC monocrystalline film was performed by the MPCVD method while applying bias under the conditions shown in Table 1 using an MPCVD apparatus (apparatus name: microwave diamond film forming apparatus, manufactured by Nihon Koshuha Co., Ltd.).

**[Table 1]**

| | |
|---|---|
| CVD | MPCVD |
| Frequency (MHz) | 2540±30 |
| Pressure (kPa) | 13.3 |
| Microwave power (kW) | 1.8 |
| Bias voltage (V) | 500 |
| CH₄ ratio (96) | 5 |
| Temperature (°C) | 910-950 |
| Keep time (min) | 10 |

### [Evaluation of Diamond Nuclei]

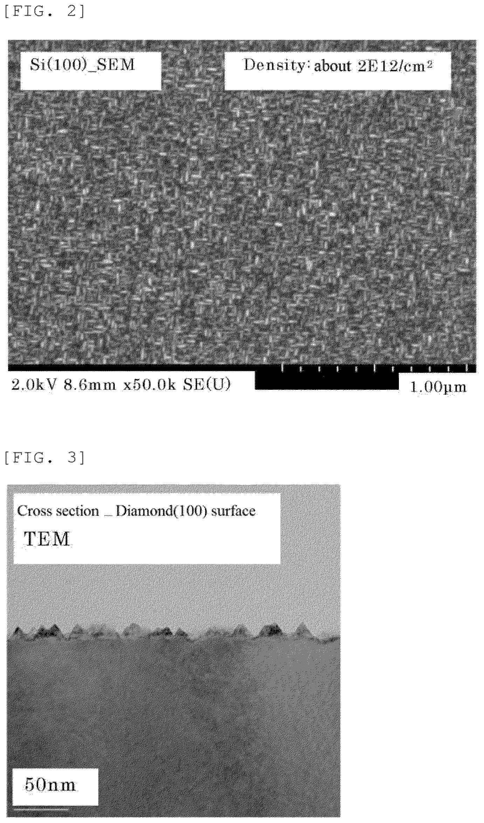

Here, the average surface density of the diamond nuclei formed in the third step was measured. The measurement was performed by using a SEM (Scanning Electron Microscope) and calculation software (WinROOF 2018). As a result, the average surface density was about 2×10¹²/cm² (upper limit of measurement). FIG. 2 shows an observation view of the substrate surface on which diamond nuclei are formed viewed by the SEM.

FIG. 3 shows the section of the substrate surface layer on which the diamond nuclei are formed viewed by a TEM (Transmission Electron Microscope). The form of the diamond crystal nuclei at this time was confirmed to be pyramidal.

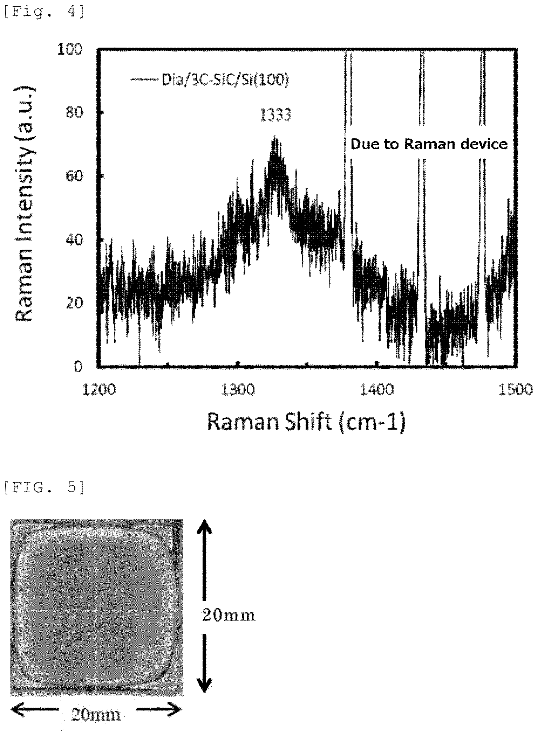

Furthermore, the diamond nuclei generated under the above conditions were evaluated with Raman spectroscopy. The results are shown in FIG. 4. Raman shift peak was observed at 1333cm⁻¹, and thus they were confirmed to be diamond nuclei.

### <Fourth Step>

A monocrystalline diamond film with 20 mm square size was caused to grow by the MPCVD method under the conditions shown in Table 2.

**[Table 2]**

| | |
|---|---|
| CVD | MPCVD |
| Pressure (kPa) | 13.3 |
| Microwave power (kW) | 3.4 |
| CH₄ ratio (96) | 2 |
| Temperature (°C) | 1091-1100 |
| Keep time (min) | 1200 |

### [Evaluation of Monocrystalline Diamond Film]

FIG. 5 shows the formed monocrystalline diamond film with 20 mm square size.

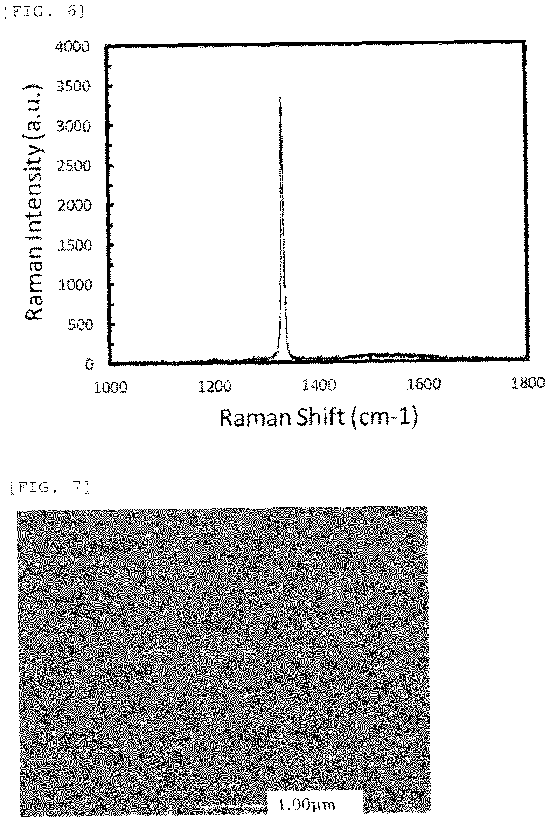

As shown in the evaluation results by Raman spectroscopy of FIG. 6, Raman shift peak was observed at 1333cm⁻¹, and thus the film was confirmed to be a high purity monocrystalline diamond film.

Moreover, as can be seen in the observation view of the surface of the monocrystalline diamond film by the SEM shown in FIG. 7, neither abnormal growth nor significant crystal grain boundary was observed.

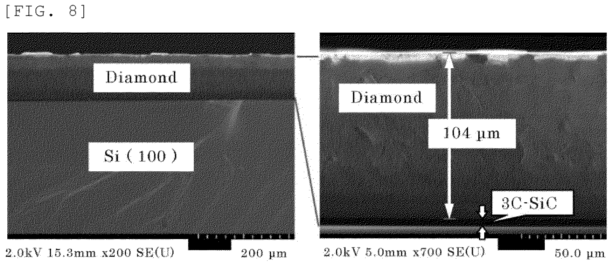

Furthermore, the grown monocrystalline diamond film was cleaved and observed with the SEM. FIG. 8 shows the results. As can be seen in FIG. 8, the film thickness was confirmed to be 104 um. It is observed that a monocrystalline diamond film is formed on the 3C-SiC monocrystalline film with an extremely small thickness, which remained unconverted into diamond nuclei from the 3C-SiC monocrystalline film in the third step.

### (Comparative Example 1)

A monocrystalline diamond film was caused to grow under the same conditions as in Example 1 except that the formation of a 3C-SiC monocrystalline film in the second step was performed by a CVD method.

At this time, the CVD was performed under conditions of a CH₄ atmosphere at 900 to 1100°C for 5 minutes. A SiC layer with about 100 nm thickness was thereby formed on a monocrystalline silicon substrate.

Thereafter, diamond nuclei were formed under the same conditions as in the third step of Example 1, the average surface density was about 1×10⁸/cm². Thus, high density diamond nuclei could not be formed.

Furthermore, a monocrystalline diamond film that was caused to grow under the same conditions as in the fourth step of Example 1 had grain boundaries with island shapes. Thus, a uniform monocrystalline diamond film could not be formed.

### (Comparative Example 2)

A monocrystalline diamond film was caused to grow under the same conditions as in Example 1 except that the formation step of diamond nuclei in the third step was performed without applying a bias voltage.

As a result, the average surface density was less than 1×10⁴/cm², and thus high density diamond nuclei could not be formed.

Furthermore, a monocrystalline diamond film that was caused to grow under the same conditions as in the fourth step of Example 1 had grain boundaries with island shapes. Thus, a uniform monocrystalline diamond film could not be formed.

It should be noted that the present invention is not limited to the above-described embodiments. The embodiments are just examples, and any examples that substantially have the same configuration and demonstrate the same functions and effects as those in the technical concept disclosed in claims of the present invention are included in the technical scope of the present invention.

## Claims

1. A method for forming a monocrystalline diamond film on a monocrystalline silicon substrate, the method comprising:
a first step of preparing a monocrystalline silicon substrate having a plane orientation of (100) or (111), as the monocrystalline silicon substrate;
a second step of performing an RTA treatment on the monocrystalline silicon substrate prepared in the first step in a carbon-containing atmosphere to form a 3C-SiC monocrystalline film on a surface of the monocrystalline substrate;
a third step of converting the 3C-SiC monocrystalline film into a diamond nucleus by using a microwave plasma CVD method, in which a bias voltage is applied in a carbon-containing atmosphere, to form the diamond nucleus on the monocrystalline silicon substrate after the second step; and
a fourth step of causing a monocrystalline diamond film to grow on the monocrystalline silicon substrate by using the microwave plasma CVD method in a carbon-containing atmosphere after the third step.

2. The method for forming a monocrystalline diamond film according to claim 1, wherein the 3C-SiC monocrystalline film formed in the second step has a thickness of equal to or more than 0.5 nm and equal to or less than 10 nm, and has a carbon concentration higher than an Si concentration at an outermost surface of the 3C-SiC monocrystalline film.

3. The method for forming a monocrystalline diamond film according to claim 1 or 2, wherein the carbon-containing atmosphere is an atmosphere containing equal to or more than 0.5% and equal to or less than 10% of CH₄, and a heat treatment temperature is equal to or more than 1100°C and equal to or less than 1350°C in the second step.

4. The method for forming a monocrystalline diamond film according to any one of claims 1 to 3, wherein the third step is performed after the monocrystalline silicon substrate, on the surface of which the 3C-SiC monocrystalline film is formed, is divided into a size that can be placed in a microwave plasma CVD apparatus.

5. The method for forming a monocrystalline diamond film according to any one of claims 1 to 4, wherein the diamond nucleus formed in the third step has average surface density of equal to or more than 1×10¹¹/cm².

6. The method for forming a monocrystalline diamond film according to any one of claims 1 to 5, wherein the carbon-containing atmosphere is an atmosphere containing equal to or more than 0.5% and equal to or less than 5.5% of CH₄, a bias voltage is equal to or more than 400 V and equal to or less than 800 V, and a heat treatment temperature is equal to or more than 900°C and equal to or less than 1200°C in the third step.

7. The method for forming a monocrystalline diamond film according to any one of claims 1 to 6, wherein the carbon-containing atmosphere is an atmosphere containing equal to or more than 0.5% and equal to or less than 5.5% of CH₄, and a heat treatment temperature is equal to or more than 850°C and equal to or less than 1150°C in the fourth step.

8. The method for forming a monocrystalline diamond film according to any one of claims 1 to 7, wherein the monocrystalline diamond film that is caused to grow in the fourth step has a thickness of equal to or more than 50 um.
